# FASCICULE DE BREVET EUROPEEN

(11) **EP 3 445 142 B1**
(45) Date de publication et mention de la délivrance du brevet: **11.12.2019**
(21) Numéro de dépôt: 18187991.7
(22) Date de dépôt: 08.08.2018
(51) Int. Cl.: H05K 7/20

(54) **EQUIPEMENT ÉLECTRONIQUE D'UN VÉHICULE FERROVIAIRE**
ELEKTRONISCHE AUSSTATTUNG EINES SCHIENENFAHRZEUGS
ELECTRONIC EQUIPMENT OF A RAILWAY VEHICLE

(30) Priorité: 18.08.2017 FR 1757758
(43) Date de publication de la demande: 20.02.2019
(73) Titulaire: ALSTOM Transport Technologies, 93400 Saint-Ouen (FR)
(72) Inventeur: DELVAL, Damien, 59600 ASSEVENT (FR)
(74) Mandataire: Lavoix

(56) Documents cités:
- EP-A1- 1 259 104
- FR-A1- 2 875 374
- JP-A- H11 251 499
- US-A1- 2013 016 481
- US-A1- 2015 371 920
- US-A1- 2016 352 242

## Description

La présente invention concerne un équipement électronique d'un véhicule ferroviaire, du type comprenant :
- une structure,
- une carte électronique,
- un ensemble de composants électroniques connectés à la carte électronique, lesdits composants électroniques étant disposés à l'intérieur de la structure,
- un module de refroidissement, configuré pour refroidir les composants électroniques en évacuant vers l'extérieur de la structure au moins une partie d'une chaleur dissipée par les composants électroniques, ledit module de refroidissement étant disposé à l'extérieur de la structure, et
- une bride interposée entre le module de refroidissement et au moins une paroi de la structure, ladite bride étant en contact avec le module de refroidissement et avec ladite paroi de la structure.

L'invention concerne notamment le domaine des véhicules ferroviaires, l'équipement électronique étant destiné à être embarqué dans un véhicule ferroviaire.

L'équipement électronique est par exemple un convertisseur d'énergie électrique.

On connaît des documents US2016/352242 ou FR 2 875 374 un convertisseur d'énergie électrique du type précité. Le convertisseur comprend une section de circuit de puissance, une section de circuit de commande et une structure pour loger lesdites sections. Le convertisseur comprend également un premier radiateur configuré pour diffuser une partie de la chaleur générée par la section de circuit de puissance vers l'extérieur de la structure. Entre le premier radiateur et la section de circuit de puissance est disposée une première couche thermo-conductrice, destinée à transférer de la chaleur de la section de circuit de puissance vers le premier radiateur.

De manière similaire, le convertisseur comporte également un deuxième radiateur configuré pour diffuser une partie de la chaleur générée par la section de circuit de commande vers l'extérieur de la structure. Entre le deuxième radiateur et la section de circuit de commande est disposée une deuxième couche thermo-conductrice, destinée à transférer de la chaleur de la section de circuit de commande vers le deuxième radiateur.

Toutefois, le refroidissement d'un tel convertisseur d'énergie électrique n'est pas toujours optimal, et la température à l'intérieur de la structure est parfois trop élevée. Ce problème est davantage aggravé par la densification des convertisseurs d'énergie électrique où plus d'énergies sont mise dans les espaces plus petits des convertisseurs.

Le but de l'invention est de proposer un équipement électrique avec un refroidissement amélioré, permettant de limiter l'augmentation de la température à l'intérieur de la structure lors du fonctionnement de l'équipement électrique.

A cet effet, l'invention a pour objet un équipement électronique d'un véhicule ferroviaire du type précité, dans lequel la bride est réalisée en un matériau thermiquement isolant.

En effet, l'inventeur a mis en évidence que, de manière surprenante, dans les équipements électriques de l'état de la technique, la température excessive à l'intérieur de la structure résulte du fait qu'une partie de la chaleur diffusée des composants électroniques vers le radiateur n'est pas évacuée vers l'extérieur, mais renvoyée vers la structure via le contact de la structure avec le radiateur. Cette chaleur rayonne depuis la structure vers les composants électroniques contenus dans la structure.

L'inventeur a découvert que l'utilisation d'une bride réalisée en un matériau thermiquement isolant permet de diminuer le transfert de chaleur vers l'intérieur de la structure et ainsi de maximiser le transfert de chaleur depuis le radiateur vers l'extérieur de la structure.

Suivant d'autres aspects avantageux de l'invention, l'équipement électrique comprend une ou plusieurs des caractéristiques suivantes, prises isolément ou suivant toutes les combinaisons techniquement possible :
- les composants électroniques sont en contact avec le module de refroidissement ;
- la structure comprend au moins quatre parois latérales, la bride étant interposée entre le module de refroidissement et chacune desdites au moins quatre parois latérales, ladite bride étant en contact avec le module de refroidissement et avec chacune desdites au moins quatre parois latérales ;
- chaque paroi latérale comprend un flanc latéral sensiblement orthogonal à la carte électronique et un rebord d'appui sensiblement orthogonal au flanc latéral, la bride étant interposée entre le rebord d'appui et le module de refroidissement, la bride étant en contact avec le rebord d'appui.
- la bride est fixée au rebord d'appui d'au moins une des parois latérales ;
- la bride est fixée au rebord d'appui d'au moins une des parois latérales par au moins une vis imperdable ;
- les composants électroniques comprennent des transistors bipolaires à grille isolée ;
- l'équipement électronique est un convertisseur d'énergie électrique.

Ces caractéristiques et avantages de l'invention apparaîtront plus clairement à la lecture de la description qui va suivre, donnée uniquement à titre d'exemple non limitatif, et faite en référence aux dessins annexés, sur lesquels :
- la figure 1 est une vue partielle et en perspective d'un équipement électronique selon un mode de réalisation de l'invention ;
- la figure 2 est une vue partielle agrandie de l'équipement électronique de la figure 1 à proximité de la bride isolante;

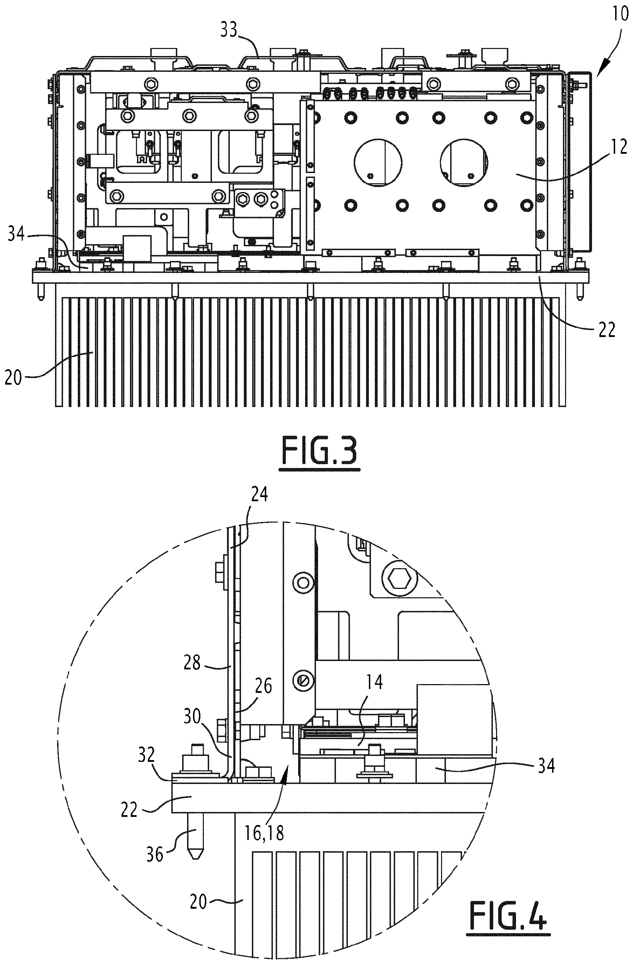

- la figure 3 est une vue de face de l'équipement électronique de la figure 1, dans la structure;
- la figure 4 est une vue partielle agrandie de la figure 3 à proximité de la bride isolante.

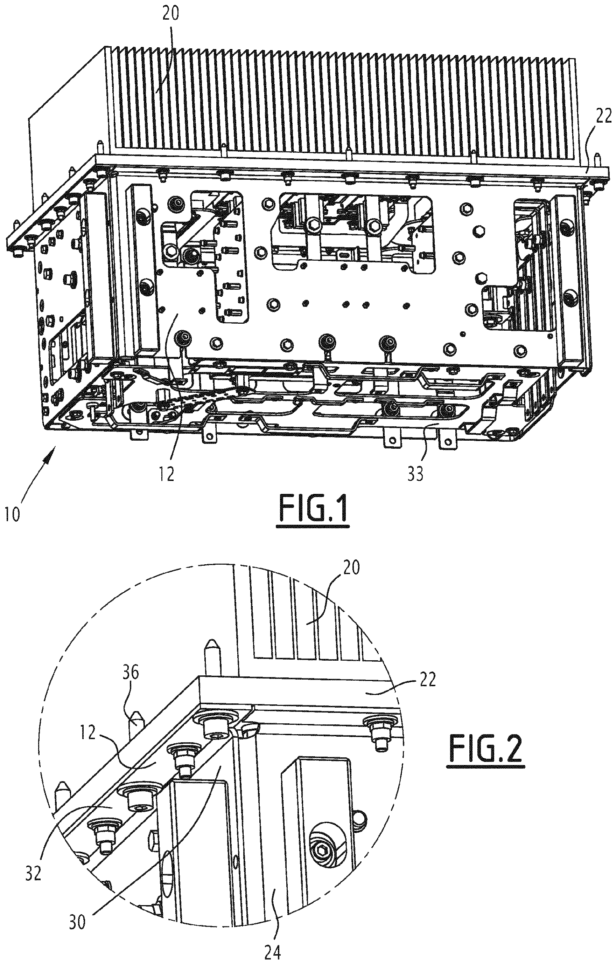

On a représenté sur la figure 1 un équipement électronique selon un mode de réalisation de l'invention.

L'équipement électronique 10 est un équipement électronique d'un véhicule ferroviaire.

L'équipement électronique 10 comprend une structure 12, une carte électronique 14, un ensemble 16 de composants électroniques 18, un module de refroidissement 20, et une bride 22 thermiquement isolante.

La structure 12 forme une enceinte. Dans l'exemple représenté, la structure 12 comprend quatre parois latérales 24 et un capot, non représenté pour montrer l'intérieur de la structure 12.

Chaque paroi latérale 24 s'étend, dans une direction sensiblement orthogonale à la carte électronique 14, entre un bord proximal et un bord distal. Chaque paroi latérale 24 est reliée à deux parois latérales qui lui sont adjacentes.

Chaque paroi latérale 24 comporte une face interne 26 orientée vers l'intérieur de la structure 12 et une face externe 28 orientée vers l'extérieur de la structure 12.

Dans le mode de réalisation illustré sur la Figure 1, chaque paroi latérale 24 comprend un flanc latéral 30 sensiblement orthogonal à la carte électronique 14 et un rebord d'appui 32 sensiblement orthogonal au flanc latéral 30, formant le bord proximal de la paroi latérale 24.

Le capot 33 s'étend dans un plan longitudinal, sensiblement orthogonal aux parois latérales 24. Le capot 33 prend appui sur les bords distaux d'au moins une partie des parois latérales 24. Dans le mode de réalisation décrit, le capot 33 prend appui sur les bords distaux des quatre parois latérales 24.

La structure 12 forme ainsi une enceinte délimitée par les parois latérales 24 et le capot 33. Cette enceinte est ouverte, i.e. ne comporte pas de deuxième capot longitudinal qui serait relié aux bords proximaux des parois latérales.

Comme décrit ci-après, la carte électronique 14 et les composants électroniques 18 sont reçus dans cette enceinte.

Les composantes électroniques 18 sont connectés à la carte électronique 14. Les composants électroniques 18 sont disposés à l'intérieur de la structure 12, en particulier à l'intérieur de l'enceinte délimitée par la structure 12.

Les composants électroniques comprennent par exemple des transistors.

Selon un mode de réalisation, l'ensemble de composants électroniques 16 comporte au moins un module de commutation 34, chaque module de commutation 34 étant formé de deux interrupteurs connectés en série. Chaque interrupteur comporte par exemple un transistor bipolaire à grille isolée, également appelé IGBT (de l'anglais *Insulated Gate Bipolar Transistor*). En variante, chaque interrupteur comporte un transistor bipolaire, ou un transistor de type JFET (de l'anglais *Junction Field Effect Transistor*), ou encore un thyristor, tel qu'un thyristor à extinction par la gâchette, ou GTO (de l'anglais *Gate Turn-Off Thyristor*).

Les composants électriques 18 sont en contact direct avec le module de refroidissement 20. Dans une configuration, les composants électriques 18 sont fixés au module de refroidissement 20.

Le module de refroidissement 20 est disposé du côté proximal des parois latérales 24, comme représenté sur la figure 1.

Ainsi, le module de refroidissement forme un deuxième capot longitudinal fermant l'enceinte formée par la structure 12.

Le module de refroidissement 20 est disposé à l'extérieur de la structure 12. Le module de refroidissement 20 est configuré pour refroidir l'ensemble 16 des composants électroniques 18, en évacuant vers l'extérieur de la structure 12 au moins une partie de la chaleur dissipée par les composants électroniques 18, en fonctionnement. Le module de refroidissement 20 est également apte à refroidir la carte électronique 14.

Le module de refroidissement 20 comprend par exemple un radiateur à ailettes, un flux d'air étant alors destiné à circuler entre les ailettes du radiateur pour évacuer la chaleur dissipée par les composants électroniques 18 lors de leur fonctionnement. En variante ou en complément, le module de refroidissement 20 comporte un module de Peltier ou encore un caloduc.

La bride 22 est interposée entre le module de refroidissement 20 et au moins une paroi latérale 24 de la structure 12, la bride 22 étant en contact avec le module de refroidissement 20 et avec le bord proximal d'au moins une paroi 24.

Dans l'exemple illustré, la bride 22 est interposée entre le module de refroidissement 20 et chacune des quatre parois latérales 24, la bride 22 étant en contact avec le module de refroidissement 20 et avec chacune des quatre parois latérales 24.

Dans l'exemple illustré, la bride 22 est interposée entre le module de refroidissement 20 et le rebord d'appui 32 de chaque paroi latérale 24, la bride 22 étant en contact avec le module de refroidissement 20 et le rebord d'appui 32. Dans ce cas, la bride 22 est de préférence fixée au rebord d'appui 32 d'au moins une des parois latérales 24, ou encore de préférence fixée par au moins une vis imperdable 36.

La bride 22 est réalisée en un matériau thermiquement isolant, par exemple réalisée en Muscotherm®. Ainsi, la bride 22 est apte à éviter la formation d'un pont thermique entre le module de refroidissement 20, via la bride 22, et la structure 12.

Grâce à l'invention décrite ci-dessus, le transfert thermique entre le module de refroidissement 20 et la structure 12, et l'augmentation de la température à l'intérieur de la structure 12 due à ce transfert est sensiblement réduit. Notamment, une partie de la chaleur qui passe entre le module de refroidissement 20 et la structure 12 est évacuée vers l'extérieur via le module de refroidissement 20, au lieu d'être renvoyée vers la structure 12 via le contact entre la structure 12 et le module de refroidissement 20. Ainsi, un transfert de chaleur du module de refroidissement 20 vers la structure 12 et un rayonnement de cette chaleur vers les composants électroniques 18 contenus dans la structure 12 sont évités.

## Revendications

1. Equipement électronique (10) d'un véhicule ferroviaire, comprenant :
- une structure (12),
- une carte électronique (14),
- un ensemble (16) de composants électroniques (18) connectés à la carte électronique (14), lesdits composants électroniques (18) étant disposés à l'intérieur de la structure (12),
- un module de refroidissement (20), configuré pour refroidir les composants électroniques (18) en évacuant vers l'extérieur de la structure (12) au moins une partie d'une chaleur dissipée par les composants électroniques (18), ledit module de refroidissement (20) étant disposé à l'extérieur de la structure (12), et
- une bride (22) interposée entre le module de refroidissement (20) et au moins une paroi de la structure (12), ladite bride (22) étant en contact avec le module de refroidissement (20) et avec ladite paroi de la structure (12),
**caractérisé en ce que** la bride (22) est réalisée en un matériau thermiquement isolant.

2. Equipement électronique (10) selon la revendication 1, dans lequel les composants électroniques (18) sont en contact avec le module de refroidissement (20).

3. Equipement électronique (10) selon l'une quelconque des revendications 1 ou 2, dans lequel la structure (12) comprend au moins quatre parois latérales (24), la bride (22) étant interposée entre le module de refroidissement (20) et chacune desdites au moins quatre parois latérales (24), ladite bride (22) étant en contact avec le module de refroidissement (20) et avec chacune desdites au moins quatre parois latérales (24).

4. Equipement électronique (10) selon la revendication 3, dans lequel chaque paroi latérale (24) comprend un flanc latéral (30) sensiblement orthogonal à la carte électronique (14) et un rebord d'appui (32) sensiblement orthogonal au flanc latéral (30), la bride (22) étant interposée entre le rebord d'appui (32) et le module de refroidissement (20), la bride (22) étant en contact avec le rebord d'appui (32).

5. Equipement électronique (10) selon la revendication 4, dans lequel la bride (22) est fixée au rebord d'appui (32) d'au moins une des parois latérales (24).

6. Equipement électronique (10) selon l'une quelconque des revendications 4 ou 5, dans lequel la bride (22) est fixée au rebord d'appui (32) d'au moins une des parois latérales (24) par au moins une vis imperdable (36).

7. Equipement électronique (10) selon l'une quelconque des revendications 1 à 6, dans lequel les composants électroniques (18) comprennent des transistors bipolaires à grille isolée.

8. Equipement électronique (10) selon l'une quelconque des revendications 1 à 7, dans lequel l'équipement électronique (10) est un convertisseur d'énergie électrique.

## Patentansprüche

1. Elektronische Ausrüstung (10) eines Schienenfahrzeugs, umfassend:
- einen Aufbau (12),
- eine elektronische Platine (14),
- eine Baugruppe (16) von elektronischen Komponenten (18), die mit der elektronischen Platine (14) verbunden sind, wobei die elektronischen Komponenten (18) im Inneren des Aufbaus (12) angeordnet sind,
- ein Kühlmodul (20), das ausgebildet ist, die elektronischen Komponenten (18) zu kühlen, wobei mindestens ein Teil der von den elektronischen Komponenten (18) erzeugten Wärme in Bezug auf den Aufbau (12) nach außen abgeführt wird, wobei das Kühlmodul (20) außerhalb des Aufbaus (12) angeordnet ist, und
- einen Flansch (22) der zwischen dem Kühlmodul (20) und mindestens einer Wand des Aufbaus (12) angeordnet ist, wobei der Flansch (22) in Kontakt mit dem Kühlmodul (20) und mit der Wand des Aufbaus (12) ist,
**dadurch gekennzeichnet, dass** der Flansch (22) zu aus einem thermisch isolierenden Material hergestellt ist.

2. Elektronische Ausrüstung (10) nach Anspruch 1, bei der die elektronischen Komponenten (18) in Kontakt mit dem Kühlmodul (20) sind.

3. Elektronische Ausrüstung (10) nach einem beliebigen der Ansprüche 1 oder 2, bei der der Aufbau (12) mindestens vier Seitenwände (24) umfasst, wobei der Flansch (22) zwischen dem Kühlmodul (20) und jeder der mindestens vier Seitenwände (24) angeordnet ist, wobei der Flansch (22) in Kontakt mit dem Kühlmodul (20) und mit jeder der mindestens vier Seitenwände (24) ist.

4. Elektronische Ausrüstung (10) nach Anspruch 3, bei der jede Seitenwand (24) eine Seitenflanke (30) im Wesentlichen senkrecht zur elektronischen Platine (14) und einen Abstützrand (32) im Wesentlichen senkrecht zur Seitenflanke (30) umfasst, wobei der Flansch (22) zwischen dem Abstützrand (32) und dem Kühlmodul (20) angeordnet ist und der Flansch (22) in Kontakt mit dem Abstützrand (32) ist.

5. Elektronische Ausrüstung (10) nach Anspruch 4, bei der der Flansch (22) an dem Abstützrand (32) mindestens einer der Seitenwände (24) befestigt ist.

6. Elektronische Ausrüstung (10) nach einem beliebigen der Ansprüche 4 oder 5, bei der der Flansch (22) an dem Abstützrand (32) mindestens einer der Seitenwände (24) durch mindestens eine unverlierbare Schraube (36) befestigt ist.

7. Elektronische Ausrüstung (10) nach einem beliebigen der Ansprüche 1 bis 6, bei der die elektronischen Komponenten (18) bipolare Transistoren mit isoliertem Gate umfassen.

8. Elektronische Ausrüstung (10) nach einem beliebigen der Ansprüche 1 bis 7, bei der die elektronische Ausrüstung (10) ein elektrischer Energiewandler ist.

## Claims

1. Electronic equipment (10) of a railway vehicle, comprising:
- a structure (12),
- an electronic map (14),
- an assembly (16) of electronic components (18) connected to the electronic map (14), said electronic components (18) being disposed inside the structure (12),
- a cooling module (20), configured to cool the electronic components (18) by evacuating, towards the outside of the structure (12), at least a part of a heat dissipated by the electronic components (18), said cooling module (20) being disposed outside the structure (12), and
- a flange (22) interposed between the cooling module (20) and at least one wall of the structure (12), said flange (22) being in contact with the cooling module (20) and with said wall of the structure (12),
**characterised in that** the flange (22) is produced in a thermally insulating material.

2. Electronic equipment (10) according to claim 1, in which the electronic components (18) are in contact with the cooling module (20).

3. Electronic equipment (10) according to any of the claims 1 or 2, in which the structure (12) comprises at least four lateral walls (24), the flange (22) being interposed between the cooling module (20) and each of said at least four lateral walls (24), said flange (22) being in contact with the cooling module (20) and with each of said at least four lateral walls (24).

4. Electronic equipment (10) according to claim 3, in which each lateral wall (24) comprises a lateral side (30) substantially orthogonal to the electronic map (14) and a support edge (32) substantially orthogonal to the lateral side (30), the flange (22) being interposed between the support edge (32) and the cooling module (20), the flange (22) being in contact with the support edge (32).

5. Electronic equipment (10) according to claim 4, in which the flange (22) is fixed to the support edge (32) of at least one of the lateral walls (24).

6. Electronic equipment (10) according to any of the claims 4 or 5, in which the flange (22) is fixed to the support edge (32) of at least one of the lateral walls (24) by at least one captive screw (36).

7. Electronic equipment (10) according to any of the claims 1 to 6, in which the electronic components (18) comprise bipolar transistors with an insulated gate.

8. Electronic equipment (10) according to any of the claims 1 to 7, in which the electronic equipment (10) is an electrical energy converter.
